# EUROPÄISCHE PATENTSCHRIFT

(11) **EP 3 066 901 B1**
(45) Veröffentlichungstag und Bekanntmachung des Hinweises auf die Patenterteilung: **03.04.2019**
(21) Anmeldenummer: 14793098.6
(22) Anmeldetag: 03.11.2014
(51) Int. Cl.: H05K 7/14

(54) **KOMPONENTENAUFBAUSYSTEM**
COMPONENT ASSEMBLY SYSTEM
SYSTÈME D'ASSEMBLAGE DE COMPOSANTS

(30) Priorität: 04.11.2013 DE 102013112099
(43) Veröffentlichungstag der Anmeldung: 14.09.2016
(73) Patentinhaber: Phoenix Contact GmbH & Co. KG, 32825 Blomberg (DE)
(72) Erfinder: BURY, Joachim, 31812 Bad Pyrmont (DE); SALOMON, Thomas, 33415 Verl (DE)
(74) Vertreter: Patentship Patentanwaltsgesellschaft mbH
(86) Internationale Anmeldenummer: PCT/EP2014/073545
(87) Internationale Veröffentlichungsnummer: WO 2015/063291

(56) Entgegenhaltungen:
- EP-A1- 1 587 189
- EP-A1- 1 901 598
- EP-A1- 2 157 845
- WO-A1-00/62376
- US-A- 5 775 955

## Beschreibung

Die vorliegende Erfindung betrifft ein Komponentenaufbausystem mit einer Tragprofilschiene, einem Brückenmodul und einer Funktionskomponente.

Moderne Komponentensysteme der Automatisierungstechnik bestehen typischerweise aus einer Vielzahl von Funktionskomponenten, die in einem Schaltschrank angeordnet sind. Die Verteilerfunktionen für Energie und Daten sind mit getrennten Stecksystemen realisiert. Ein schaltschrankloser Aufbau ist nicht möglich, da Peripheriegeräte nahe dem Schaltschrank mit einer sternförmigen Energieverteilung hängen. Werden Feldbuskonzepte verwendet, bei denen einzelne Komponenten auf Rückplatten aufgesetzt werden, werden auf die Rückplatten hohe Gewichtskräfte ausgeübt.

Die Druckschrift WO 2004/075356 A1 beschreibt ein modulares elektrisches Gerät, bei dem die einzelnen Funktionskomponenten an Rückplatten befestigt werden.

In der EP 1 901 598 A1 ist ein modulares Automatisierungsgerät mit einer Trageschiene und vier Baugruppen offenbart.

Es ist die der Erfindung zugrundeliegende Aufgabe, ein Komponentenaufbausystem anzugeben, bei dem die Montage der Funktionskomponenten verbessert wird.

Diese Aufgabe wird durch den Gegenstand mit den Merkmalen nach dem unabhängigen Anspruch gelöst. Vorteilhafte Ausführungsformen der Erfindung sind Gegenstand der Figuren, der Beschreibung und der abhängigen Ansprüche.

Gemäß einem ersten Aspekt der Erfindung wird die Aufgabe durch ein Komponentenaufbausystem mit einer Tragprofilschiene gelöst, mit einer Funktionskomponente; einem Brückenmodul zum elektrischen Verbinden einer Funktionskomponente, das eine Modulhalteeinrichtung zum Halten des Brückenmoduls auf der Tragprofilschiene umfasst; wobei die Funktionskomponente zum teilweisen Aufsetzen auf das Brückenmodul ausgebildet ist, und wobei die Funktionskomponente eine Komponentenhalteeinrichtung zum Halten der Funktionskomponente an der Tragprofilschiene umfasst. Dadurch wird beispielsweise der technische Vorteil erreicht, dass das Gewicht der Funktionskomponente statt auf dem Brückenmodul auf der Tragprofilschiene lastet.

Das Komponentenaufbausystem kann beispielsweise ein Feldbussystem sein.

In einer vorteilhaften Ausführungsform ist die Modulhalteeinrichtung ausgebildet, eine Rastverbindung zwischen dem Brückenmodul und der Tragprofilschiene herzustellen.

In einer weiteren vorteilhaften Ausführungsform ist die Modulhalteeinrichtung, insbesondere durch ein Schwenken des Brückenmoduls, auf die Tragprofilschiene aufrastbar.

In einer weiteren vorteilhaften Ausführungsform des Komponentenaufbausystems umfasst die Modulhalteeinrichtung ein die Tragprofilschiene umgreifendes starres Halteelement und ein gegenüber dem starren Halteelement angeordnetes federelastisches Halteelement zum Aufrasten auf die Tragprofilschiene.

In einer weiteren vorteilhaften Ausführungsform des Komponentenaufbausystems umfasst die Tragprofilschiene ein Hinterschnittprofil, das mit der Modulhalteeinrichtung und/oder mit der Komponentenhalteeinrichtung zusammenwirkt.

In einer weiteren vorteilhaften Ausführungsform des Komponentenaufbausystems ist die Tragprofilschiene mehrstückig mit einem ersten Tragprofilelement und einem zweiten oder einstückig gebildet.

In einer weiteren vorteilhaften Ausführungsform des Komponentenaufbausystems sind das Brückenmodul und/oder die Funktionskomponente auf oder entlang der Tragprofilschiene verschiebbar.

In einer weiteren vorteilhaften Ausführungsform des Komponentenaufbausystems umfasst das Komponentenaufbausystem ein Klemmelement zum Festsetzen des Brückenmoduls gegen die Verschiebbarkeit auf der Tragprofilschiene, wobei das Klemmelement mit dem Brückenmodul verbindbar ist.

In einer weiteren vorteilhaften Ausführungsform des Komponentenaufbausystems ist das Klemmelement mit dem Brückenmodul kraftschlüssig oder formschlüssig, insbesondere mittels einer T-Nut/Feder-Verbindung oder einer Schwalbenschwanzverbindung oder einer Schraubverbindung oder einer Klemmverbindung, verbindbar.

In einer weiteren vorteilhaften Ausführungsform des Komponentenaufbausystems das Klemmelement ausgebildet ist, die Tragprofilschiene formschlüssig zu umgreifen und/oder kraftschlüssig zu klemmen.

In einer weiteren vorteilhaften Ausführungsform des Komponentenaufbausystems ist das Klemmelement einen nach außen geführten Erdungsanschluss umfasst, welcher mit der Tragprofilschiene elektrisch leitend verbindbar.

In einer weiteren vorteilhaften Ausführungsform des Komponentenaufbausystems umfasst das Brückenmodul Steckverbindungen zum elektrischen Verbinden mit der Funktionskomponente.

In einer weiteren vorteilhaften Ausführungsform des Komponentenaufbausystems sind die Funktionskomponente und das Brückenmodul mittels einer formschlüssigen Verbindung, insbesondere einer Feder-Nut-verbindung, verbindbar, um die auf die Verbindung zwischen dem Verbindungsmodul und der Funktionskomponente wirkenden Zugkräfte entlang einer Tragprofilschiene aufzunehmen.

In einer weiteren vorteilhaften Ausführungsform des Komponentenaufbausystems umfasst die Funktionskomponente eine erste Komponentenhalteeinrichtung für ein erstes Tragprofilelement und eine zweite Komponentenhalteeinrichtung für ein zweites Tragprofilelement umfasst.

In einer weiteren vorteilhaften Ausführungsform des Komponentenaufbausystems ist die Tragprofilschiene flächenbefestigbar, beispielsweise mittels Schraubverbindungen.

In einer weiteren vorteilhaften Ausführungsform weist die Komponentenhalteeinrichtung einen verschiebbaren Rastschieber zum Untergreifen oder zum formschlüssigen Umgreifen der Tragprofilschiene auf.

In einer weiteren vorteilhaften Ausführungsform des Komponentenaufbausystems ist der Rastschieber an der Funktionskomponente zwischen einer vorgeschobenen Arretierungsstellung zum Untergreifen oder zum formschlüssigen Umgreifen der Funktionskomponente auf der Tragprofilschiene und einer zurückgezogenen Freigabestellung zum Aufsetzen der Funktionskomponente auf die Tragprofilschiene verschiebbar.

In einer weiteren vorteilhaften Ausführungsform des Komponentenaufbausystems umfasst der Rastschieber eine Druckfeder zum Unterstützen der Bewegung des Rastschiebers in die vorgeschobene Arretierungsstellung, durch die sich vom Rastschieber gegen eine Gehäusewand der Funktionskomponente abstützt.

In einer weiteren vorteilhaften Ausführungsform des Komponentenaufbausystems umfasst der Rastschieber einen Rastarm zum Einrasten des Rastschiebers in der Arretierungsstellung und zum Einrasten des Rastschiebers in der Freigabestellung.

In einer weiteren vorteilhaften Ausführungsform des Komponentenaufbausystems umfasst die Komponentenhalteeinrichtung eine erste Rastöffnung und eine zweite Rastöffnung für den Rastarm.

In einer weiteren vorteilhaften Ausführungsform des Komponentenaufbausystems umfasst der Rastschieber einen Fixierfederarm zum Fixieren des Rastschiebers in der Freigabestellung.

In einer weiteren vorteilhaften Ausführungsform des Komponentenaufbausystems umfasst der Fixierfederarm ein Druckelement zum Drücken des Fixierfederarms in eine Lösestellung, in der der Rastschieber in die Arretierungsstellung verschiebbar ist.

In einer weiteren vorteilhaften Ausführungsform des Komponentenaufbausystems ist das Komponentenaufbausystem ausgebildet, dass das Druckelement beim Aufsetzen der Funktionskomponente auf die Tragprofilschiene betätigbar ist.

In einer weiteren vorteilhaften Ausführungsform des Komponentenaufbausystems umfasst der Rastschieber einen Unterstützungsabschnitt zum Unterstützen des Fixierfederarms umfasst.

In einer weiteren vorteilhaften Ausführungsform des Komponentenaufbausystems umfasst der Rastschieber eine Öffnung zum Einsetzen eines Werkzeugs, um den Rastschiebers zu verschieben.

In einer weiteren vorteilhaften Ausführungsform des Komponentenaufbausystems ist die Funktionskomponente auf das Brückenmodul aufsetzbar, und wobei die Modulhalteeinrichtung ist durch einen Gehäuserand der Funktionskomponente überdeckbar und dadurch gegen Auslösen arretierbar oder blockierbar.

Gemäß einem zweiten Aspekt der Erfindung wird die Aufgabe durch einen Rastschieber zum lösbaren Befestigen einer Funktionskomponente auf einer Tragprofilschiene gelöst, wobei der Rastschieber ausgebildet ist, die Tragprofilschiene formschlüssig zu umgreifen.

In einer weiteren vorteilhaften Ausführungsform des Rastschiebers ist der Rastschieber in eine vorgeschobene Arretierungsstellung zum Untergreifen der Funktionskomponente auf der Tragprofilschiene verschiebbar ist, und wobei der Rastschieber in eine zurückgezogene Freigabestellung zum Aufsetzen der Funktionskomponente auf die Tragprofilschiene verschiebbar ist.

In einer weiteren vorteilhaften Ausführungsform des Rastschiebers umfasst der Rastschieber eine Druckfeder zum Unterstützen der Bewegung des Rastschiebers in die vorgeschobene Arretierungsstellung.

In einer weiteren vorteilhaften Ausführungsform des Rastschiebers umfasst der Rastschieber einen Rastarm zum Einrasten des Rastschiebers in der Arretierungsstellung und zum Einrasten des Rastschiebers in der Freigabestellung.

In einer weiteren vorteilhaften Ausführungsform des Rastschiebers umfasst der Rastschieber eine erste Rastöffnung und eine zweite Rastöffnung für den Rastarm.

In einer weiteren vorteilhaften Ausführungsform des Rastschiebers umfasst der Rastschieber einen Fixierfederarm zum Fixieren des Rastschiebers in der Freigabestellung.

In einer weiteren vorteilhaften Ausführungsform des Rastschiebers umfasst der Fixierfederarm ein Druckelement zum Drücken des Fixierfederarms in eine Lösestellung, in der der Rastschieber in die Arretierungsstellung verschiebbar ist.

In einer weiteren vorteilhaften Ausführungsform des Rastschiebers ist das Druckelement beim Aufsetzen der Funktionskomponente auf die Tragprofilschiene betätigbar.

In einer weiteren vorteilhaften Ausführungsform des Rastschiebers umfasst der Rastschieber einen Unterstützungsabschnitt zum Unterstützen des Fixierfederarms.

In einer weiteren vorteilhaften Ausführungsform des Rastschiebers umfasst der Rastschieber eine Öffnung zum Einsetzen eines Werkzeugs, um den Rastschieber zu verschieben.

Der Rastschieber gemäß dem zweiten Aspekt kann die Merkmale des Rastschiebers gemäß dem ersten Aspekt umfassen.

Ausführungsbeispiele der Erfindung sind in den Zeichnungen dargestellt und werden im Folgenden näher beschrieben.

Es zeigen:
- Fig. 1: eine Querschnittsansicht eines Komponentenaufbausystems;
- Fig. 2: eine Aufsicht auf das Komponentenaufbausystem;
- Fig. 3: eine perspektivische Ansicht auf eine Tragprofilschiene mit einem Brückenmodul;
- Fig. 4: eine weitere perspektivische Ansicht auf die Tragprofilschiene mit mehreren Brückenmodulen;
- Fig. 5: eine Aufsicht auf die Tragprofilschiene mit mehreren Brückenmodulen;
- Fig. 6: eine perspektivische Ansicht auf die Tragprofilschiene mit dem Brückenmodul und einer Funktionskomponente;
- Fig. 7: eine weitere perspektivische Ansicht auf die Tragprofilschiene mit mehreren Brückenmodulen und Funktionskomponenten;
- Fig. 8: eine weitere perspektivische Ansicht auf die Tragprofilschiene mit mehreren Brückenmodulen und Funktionskomponenten;
- Fig. 9: eine Querschnittsansicht durch die Funktionskomponente auf der Tragprofilschiene;
- Fig. 10: eine vergrößerte Querschnittsansicht durch die Funktionskomponente und eine Komponentenhalteeinrichtung; und
- Fig. 11: eine weitere Ansicht des Rastschiebers in Verbindung mit der Funktionskomponente.

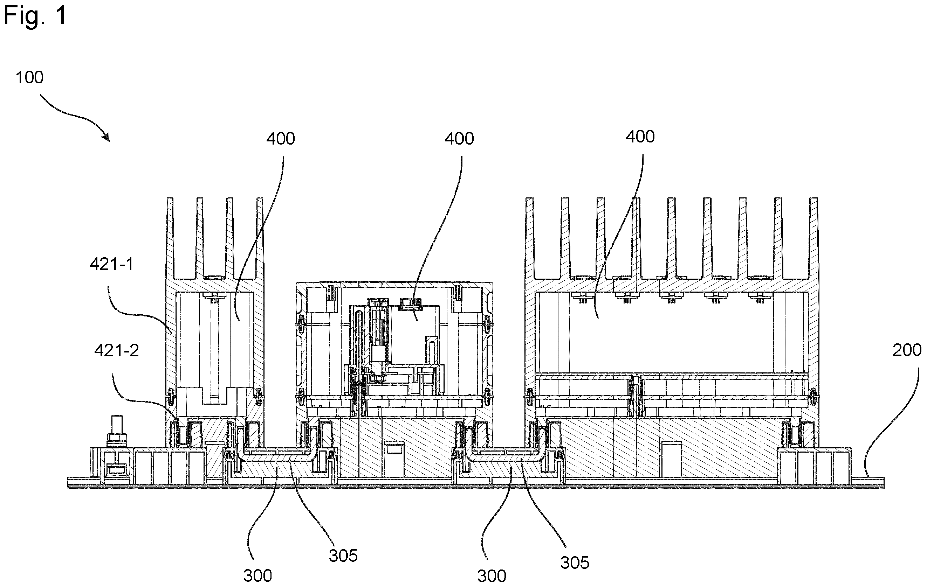

Fig. 1 zeigt eine Querschnittsansicht eines Komponentenaufbausystems 100. Das Komponentenaufbausystem 100 ist aus einem zusammensteckbaren Gehäusebaukasten zusammengesetzt, bei dem die Komponenten auf eine Tragprofilschiene 200 aufgerastet werden. Das Aufbaukonzept des Komponentenaufbausystems 100 umfasst eine Tragprofilschiene 200, Brückenmodule 300 und Funktionskomponenten 400, die jeweils aus einem Verbindungsunterteil und einem Funktionsoberteil bestehen.

Je nach Anwendungszweck können unterschiedliche Ausführungen des Aufbaukonzeptes realisiert werden. Das Aufbaukonzept ist endlos erweiterbar. Die internen elektrischen Verbindungen für Energieverteilung von beispielsweise 400V oder 24V, und der Datenbus werden gleichzeitig mit dem Zusammenstecken der Komponenten realisiert. Die Verbindungsfunktionen werden im Gehäuseunterteil 421-2 der Funktionskomponenten 400 und den Brückenmodulen 300 mit den Brückensteckern 305 realisiert. Die Funktionen Versorgen, Schützen, Schalten ergeben sich aus der Reihenfolge der Anordnung der Funktionskomponenten 400. Die Anwenderfunktionen, wie beispielsweise Versorgen, Schützen oder Schalten, sind im Gehäuseoberteil 421-1 realisiert, das über Steckkontakte mit dem Gehäuseunterteil 421-2 verbunden ist.

Das Gehäuseoberteil 421-1 hat eine definierte mechanische und elektrische Schnittstelle zum Gehäuseunterteil 421-2 und kann auch auf anderen Gehäuseunterteilen 421-2 mit gleicher Schnittstelle verwendet werden. Das Gehäuseunterteil 421-2 enthält lediglich die Verbindungstechnik. Das Gehäuseoberteil 421-1 enthält beispielsweise die Funktionen Trennen, Schützen oder Schalten. Die Wirkungsrichtung der vorgenannten Funktionen erfolgt je nach Gehäuseoberteil 421-1 und Gehäuseunterteil 421-2 in der Linie und/ oder in den Verbraucherabgang, d.h. einer Steckverbindung in dem Gehäuseoberteil 421-1. Die Verbindungstechnik kann im Gehäuseunterteil 421-2 unterbrochen sein.

Die Tragprofilschiene 200 bildet ein einteiliges Trägersystem mit einer breiten Schiene für einen Rack-Aufbau, die die Geometrie der Auflagekanten des Brückenmoduls 300 und der Funktionskomponenten 400 nachbildet. Alternativ können zwei getrennte Standard-Tragprofilschienen als zweiteiliges Trägersystem, beispielsweise mit einer Breite von 35 mm, für einen Wandaufbau verwendet werden. Das Tragprofilelement kann durch ein Hutprofil gebildet werden.

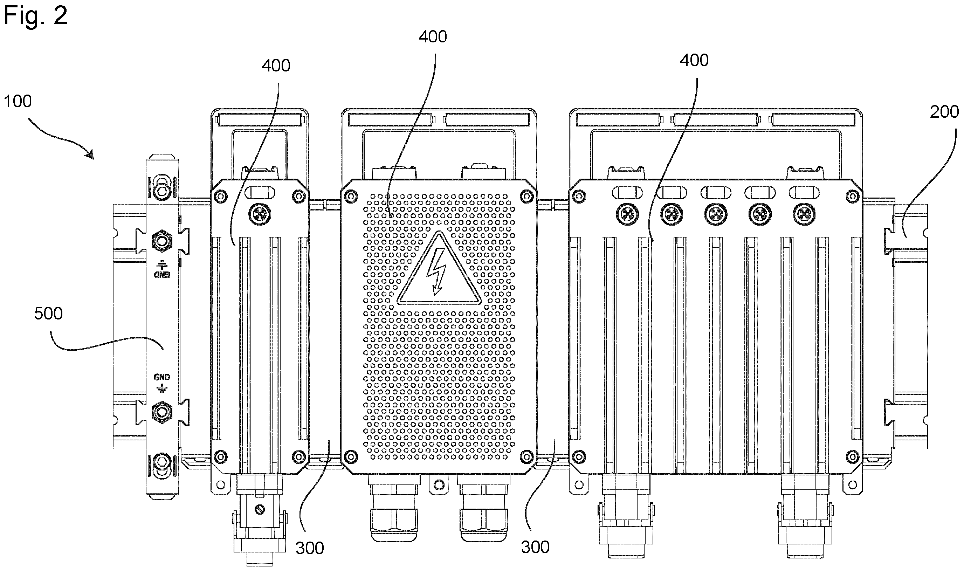

Fig. 2 zeigt eine Aufsicht auf das Komponentenaufbausystem 100. Als elektrische Verbindung für eine Energieverteilung und den Datenbus werden auf den Tragprofilschienen 200 aufrastbare Brückenmodule 300 mit nach vorne gerichteten Brückensteckern 305 aufgerastet. Die Aufsteckrichtung auf die Brückenmodule steht senkrecht zur Ebene, die die Tragprofilschienen 200 aufspannen.
Der Klemmblock 500 als Klemmelement setzt das Gesamtsystem in x-Richtung an einem Fixpunkt auf der Tragprofilschiene 200 fest. Durch diese Anordnung ist, von einem Fixpunkt aus, ein freies Atmen des Systemaufbaues in x-Richtung möglich, wie beispielsweise bei wärmebedingtem Längenwachstum. Die mechanische Klemmung dieses Fixpunktes ist zugleich die zentrale elektrische Erdung und Verbindung mit der Tragprofilschiene des Systemaufbaus.

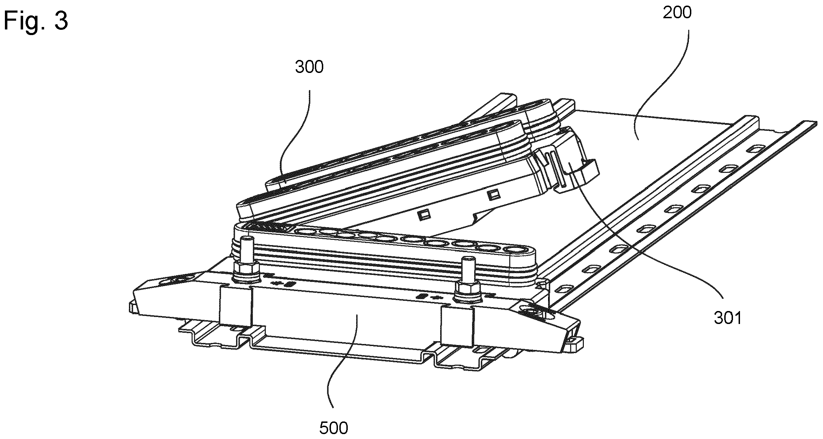

Fig. 3 zeigt eine perspektivische Ansicht auf eine Tragprofilschiene 200 mit dem Brückenmodul 300. Das Brückenmodul 300 umfasst die Steckkontakte 303 und eine Modulrasteinrichtung 301 zum Aufrasten des Brückenmoduls 300 auf die Tragprofilschiene 200 beim Aufsetzen des Brückenmoduls 300. Die Brückenmodule 300 sind nach den Aufrasten frei entlang der Tragprofilschiene 200 verschiebbar.

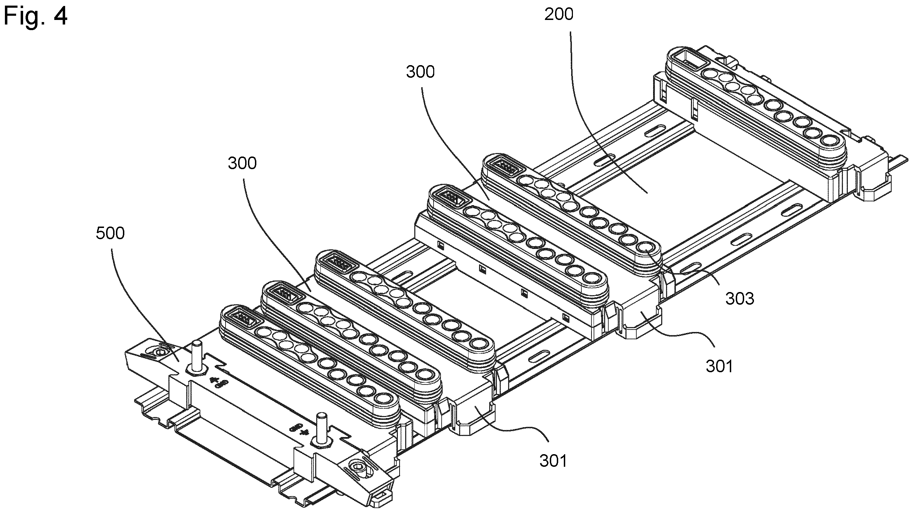

Fig. 4 zeigt eine weitere perspektivische Ansicht auf die Tragprofilschiene 200 mit mehreren Brückenmodulen 300. Die Brückenmodule 300 können in unterschiedlichen Breiten ausgeführt sein, so dass der Abstand zwischen gefügten Funktionskomponenten 400 durch die Brückenmodule 300 bestimmt wird. Dieser Abstand definiert einen Lüftungskamin zwischen den Funktionskomponenten 400, die beispielsweise ein metallisches Gehäuseoberteil 421-1 als Kühlkörper umfassen.

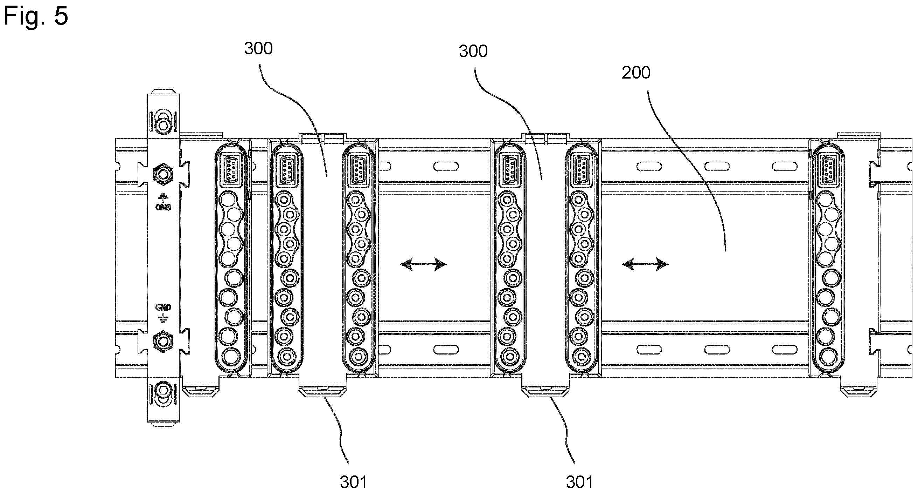

Fig. 5 zeigt eine Aufsicht auf die Tragprofilschiene 200 mit mehreren Brückenmodulen 300. Die Brückenmodule 300 sind im aufgerasteten Zustand in Pfeilrichtung seitlich verschiebbar. Durch die freie Verschiebbarkeit der Brückenmodule 300 ist ein rasterfreier Aufbau auf der Tragprofilschiene 200 möglich, aber nicht zwingend. Die mechanische Positionierung der Funktionskomponenten 400 in der Feldstation ist grundsätzlich beliebig. Die Anordnung und Abfolge in der Linie ist funktionsbestimmend.

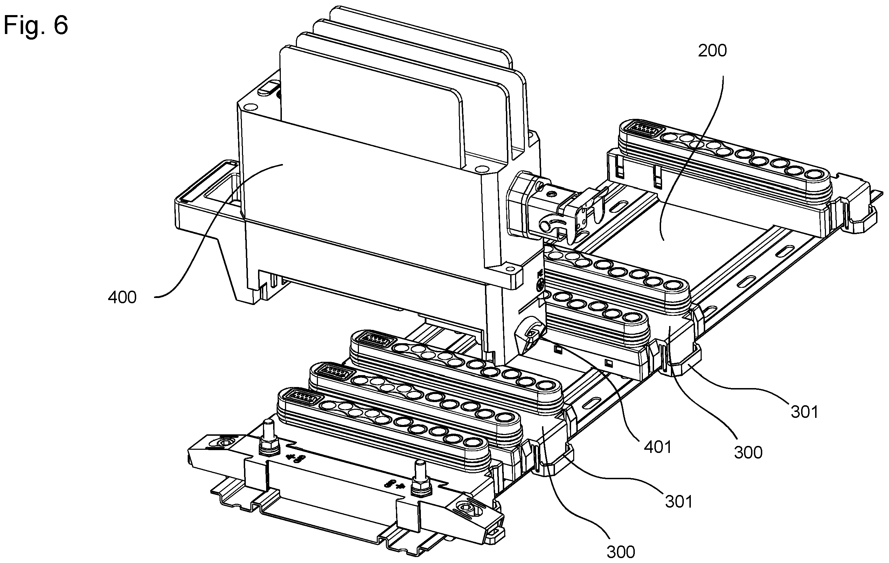

Fig. 6 zeigt eine perspektivische Ansicht auf die Tragprofilschiene 200 mit den Brückenmodulen 300 und der Funktionskomponente 400. Die Funktionskomponente 400 wird auf die Tragprofilschiene 200 senkrecht aufgesetzt, so dass diese auf die Steckverbinder 305 von zwei links und rechts passend positionierten Brückenmodulen 300 trifft. Diese Aufbaumethode lässt gleichartige Lösungen innerhalb und außerhalb eines Schaltschranks zu und ermöglicht eine Alternative zu Stromschienen-basierten Verteilungen im dem Schaltschrank.

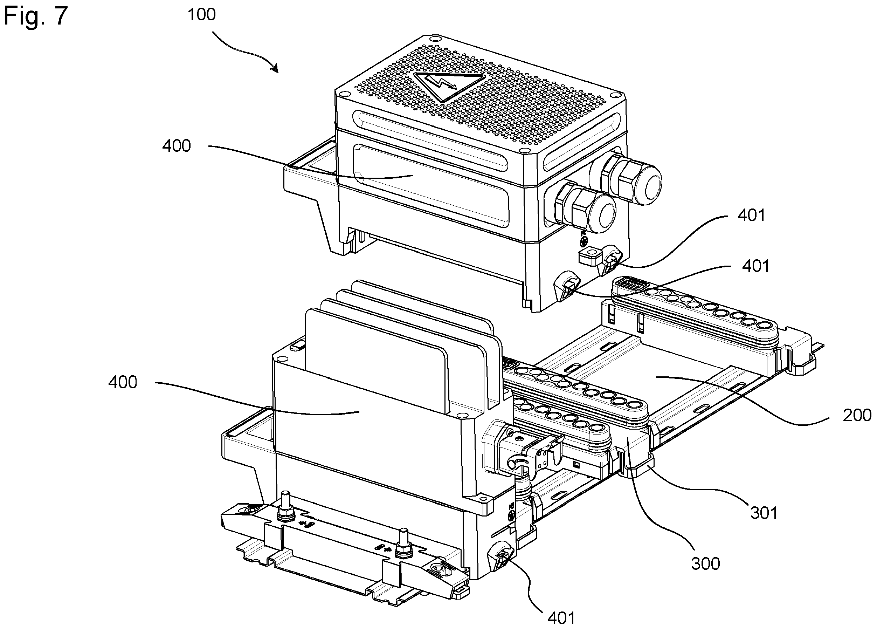

Fig. 7 zeigt eine weitere perspektivische Ansicht der Tragprofilschiene 200. Nach einem Aufsetzen der ersten Funktionskomponente 400 wird eine zweite Funktionskomponente 400 auf die Tragprofilschiene 200 aufgesetzt. Die Brückenmodule 200 sind dabei derart verschieblich, dass diese auf die Breite der jeweiligen Funktionskomponente 400 eingestellt werden können. Auch nach dem Aufsetzen und dem Fügevorgang der Funktionskomponente 400 und dem Brückenmodul 300 ist eine Verschiebung der Kombination auf der Tragprofilschiene 200 weiterhin möglich. Ein Aufrasten und Verschieben der Brückenmodule 300 und Funktionskomponenten 400 und eine Montage mit einer Arretierung von oben und unten und ein Stromverlauf sind im gefügten Verbund möglich. Die Funktionskomponenten 400 können mechanisch an den Brückenmodulen 300 befestigt oder aufgesteckt sein, so dass diese Zieh- und Steckkräfte für die weitere Montage oder Demontage der Funktionskomponenten 400 aufnehmen.

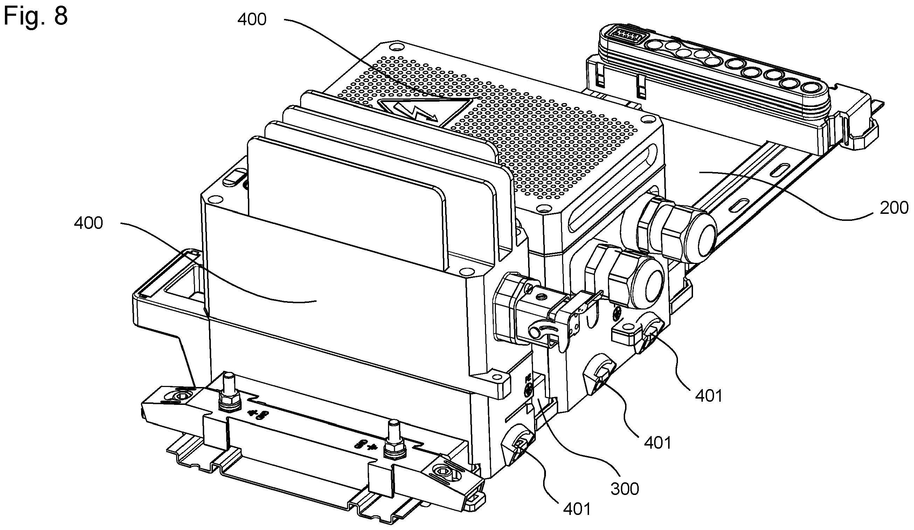

Fig. 8 zeigt eine weitere perspektivische Ansicht auf die Tragprofilschiene 200 mit mehreren Brückenmodulen 300 und Funktionskomponenten 400. Nach einem Aufbau und einer Positionierung der vollständigen gefügten Kombination der Brückenmodule 300 und der Funktionskomponenten 400 wird der Verbund an der Tragprofilschiene 200 arretiert. Zu diesem Zweck sind an den Funktionskomponenten 400 Komponentenhalteeinrichtungen 401 vorgesehen.

Durch die Komponentenhalteeinrichtungen 401 wird der gefügte Verbund gegen ein Verschieben und die Funktionskomponenten 400 gegen ein Abziehen und Verkanten gesichert. Die Brückenmodule 300, die die gefügte Kombination links- und rechtsseitig abschließen, tragen eine Vorrichtung zum einseitigen mechanischen Klemmen, wie beispielsweise eine Schraubklemme und zur PE-Kontaktierung des internen Schutzleiters auf der Tragprofilschiene 200.

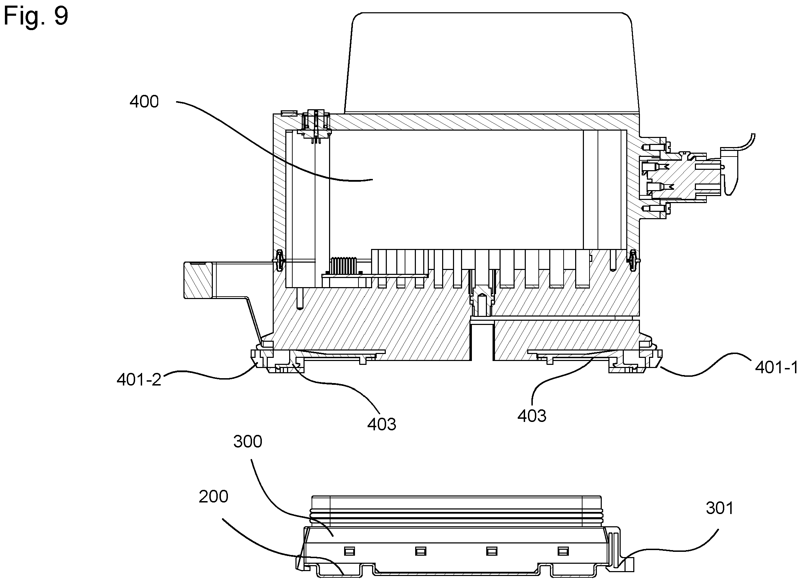

Fig. 9 zeigt eine Querschnittsansicht durch die Funktionskomponente 400 auf der Tragprofilschiene 200 und durch die Komponentenhalteeinrichtungen 401. Eine Arretierung der Funktionskomponente 400 auf der Tragprofilschiene 200 wird mittels der Komponentenhalteeinrichtungen 401-1 und 402 erreicht, die einen seitlich betätigbaren Rastschieber 403 umfassen. Die erste Komponentenhalteeinrichtung 401-1 befestigt die Funktionskomponente 400 an einem ersten Tragprofil. Die zweite Komponentenhalteeinrichtung 401-1 befestigt die Funktionskomponente 400 an einem zweiten Tragprofil.

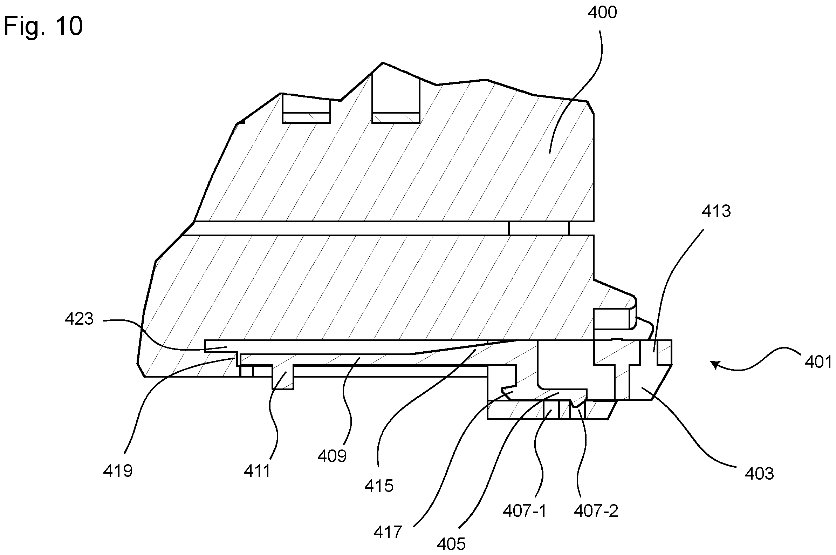

Fig. 10 zeigt zur Veranschaulichung des Rastschiebers 403 eine vergrößerte Querschnittsansicht durch die Funktionskomponente 400 und die Komponentenhalteeinrichtung 401. Der Rastschieber 403 ist an der Funktionskomponente 400 verschiebbar angeordnet und kann zwischen einer Arretierungsstellung zum Arretieren der Funktionskomponente 400 auf der Tragprofilschiene 200 und einer Freigabestellung zum Aufsetzen oder Entnehmen der Funktionskomponente 400 auf die Tragprofilschiene 200 bewegt werden. In der Arretierungsstellung hintergreift eine Befestigungsnase 417 die Tragprofilschiene 200, so das ein Formschluss entsteht. In der Freigabestellung ist die Befestigungsnase 417 zurückgezogen.

Der Rastschieber 403 umfasst einen federnden Rastarm 405, der je nach Stellung in eine erste Rastöffnung 407-1 oder eine zweite Rastöffnung 407-2 eingreift. Dadurch kann die Arretierungsstellung oder die Freigabestellung rastend aufrechterhalten werden. Ist der Rastarm 405 in der ersten Rastöffnung 407-1 angeordnet, befindet sich der Rastschieber 403 in der Arretierungsstellung. Ist der Rastarm 405 in der zweiten Rastöffnung 407-2 angeordnet, befindet sich der Rastschieber 403 in der Freigabestellung.

Der Rastschieber 403 umfasst zudem einen Fixierfederarm 409 zum Fixieren des Rastschiebers 403 in der Freigabestellung, so dass der Rastschieber 403 solange in der Freigabestellung gehalten wird, bis der Fixierarm 409 nach oben gedrückt wird. Zu diesem Zweck schlägt der Fixierfederarm 409 des Rastschiebers 403 im Inneren der Komponentenhalteeinrichtung 401 an einem Anschlag 419 an und sperrt dadurch die Bewegung des Rastschiebers 403. Der Anschlag 419 verhindert ein Verschieben des Rastschiebers 403 in Richtung der Arretierungsstellung.

Wird die Funktionskomponente 400 auf die Rastschiene 200 gesetzt, wird der Fixierfederarm 409 durch ein Druckelement 411 nach oben gedrückt, so dass der Fixierfederarm 409 in eine Lösestellung gedrückt wird, in der der Fixierfederarm 409 beim Verschieben des Rastschiebers 403 in die Ausnehmung 423 eindringen kann. In dieser Lösestellung ist der Rastschieber 403 von der Freigabestellung in die Arretierungsstellung verschiebbar und rastet anschließend in der Rastöffnung 407-1 ein. Das Druckelement 411 wird beim Aufsetzen der Funktionskomponente 400 auf die Tragprofilschiene 200 betätigt, so dass die Arretierung durch den Rastschieber 403 nur bei aufgesetzter Funktionskomponente 400 erfolgen kann.

Zur Verstärkung der Wirkung und Stabilität des Fixierfederarms 409 ist ein Unterstützungsabschnitt 415 vorgesehen, der sich im Lauf des Fixierfederarms 409 nach außen hin verbreitert. Daneben umfasst der Rastschieber 403 eine Öffnung 413 zum Einsetzen eines Werkzeugs, um den Rastschieber 403 zu verschieben, wie beispielsweise eine Schraubenzieher. Der seitlich herausziehbare Rastschieber 403 ist beispielsweise als einstückiges Kunststoffteil gebildet.

Die Feldstationen können durch Verwendung einer einfachen Einspeisung als Endgeräte einer klassischen Sternverteilung genutzt werden oder durch Verwendung eines Anschluss und Verteilermoduls (AV-Modul) zu Teilnehmern oder Knoten eines Energieverteilungsnetzwerks werden. Schalt- und Schutzorgane, Motorschalter, Buskoppler, oder I/Os, usw. können in freier, funktionsbestimmter Reihenfolge links und rechts des AV-Moduls angeordnet werden. Dadurch werden Vorteile beim Engineering durch eine sichtbare Trennung von Klein- und Niederspannungskomponenten erreicht. Mehrere Feldstationen können als Teilnehmer ein Netzwerk in beliebiger Struktur, wie beispielsweise Linie, Baum oder Ring, aufspannen.

Ein zentraler Schaltschrank innerhalb des ausgelegten Leistungsbereichs der Energieverteilung ist nicht mehr erforderlich. Durch eine geeignete Ausführung des mitgeführten Datenbusses können die Reihenfolge und die Positionen einzelner Komponenten der Feldstation vor der Inbetriebnahme auf die planungsgerechte Anordnung überprüft werden (Remote Putting into Service, Remote Service).

Das Komponentenaufbausystem 100 ermöglicht einen Aufbau von 'smarten' Installationsnetzwerken für Gleichstrom und Wechselstrom und schaltschranklose Verteilungen in geeigneten Anlagenlayouts. Das Komponentenaufbausystem kann in den Anwendungsgebieten Installation oder Energieverteilung verwendet werden. Bei einer verteilten Automatisierung ist ein Aufbau von modularen Feldstationen als Funktionsknoten in 'smarten' Installationsnetzwerken möglich. In alternativen Schaltschrank-Konzepten ist ein Aufbau von modularen Stationen im Schaltschrank ohne Stromschienen und ohne Steuerverdrahtung mit identischer Projektierung für IP20... IP6x möglich.

Durch das Komponentenaufbausystem 100 können modulare Motorschalter im Feld mit hoher Schutzart entwickelt werden. Durch das Komponentenaufbausystem 100 wird zusätzlich ein ganzheitliches Aufbaukonzept (Power & Drive, P&D) entwickelt, das die Aufgabe einer vorteilhaften Verteilung und Bereitstellung von Energie im Feld löst, beispielsweise außerhalb eines Schaltschranks. Die Modularität des Komponentenaufbausystems 100 ermöglicht die Ausweitung der Anwendung über die modulare Feldstation hinaus zur 'smarten' Energieverteilung bis hin zu einem alternativen Schaltschrankaufbau. Zudem kann eine Abdeckung des Spektrums von Stand-Alone-Funktionskomponenten als Endgeräte an einer klassisch sternförmigen Energieverteilung erreicht werden.

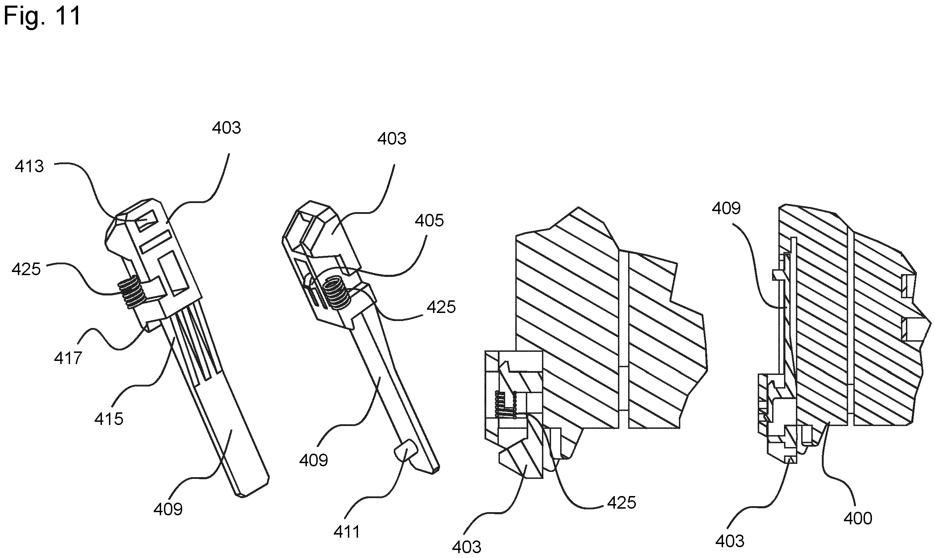

Fig. 11 zeigt eine Ansicht des Rastschiebers 403 in Verbindung mit der Funktionskomponente 400. Der Rastschieber 403 umfasst eine Druckfeder 425 zum Unterstützen der Bewegung des Rastschiebers 403 in die vorgeschobene Arretierungsstellung, durch die sich vom Rastschieber 403 gegen eine Gehäusewand der Funktionskomponente 400 abstützt. Durch die Druckfeder 425 wird der Rastschieber in die vorgeschobenen Arretierungsstellung gedrückt. Die Druckfeder 425 ist zwischen an einer Anschlagsfläche des Rastschiebers 403 und einer Anschlagsfläche der Funktionskomponente 400 angeordnet.

Alle in Verbindung mit einzelnen Ausführungsformen der Erfindung erläuterten und gezeigten Merkmale können in unterschiedlicher Kombination in dem erfindungsgemäßen Gegenstand vorgesehen sein, um gleichzeitig deren vorteilhafte Wirkungen zu realisieren.

Der Schutzbereich der vorliegenden Erfindung ist durch die Ansprüche gegeben und wird durch die in der Beschreibung erläuterten oder den Figuren gezeigten Merkmale nicht beschränkt.

### BEZUGSZEICHENLISTE

- 100: Komponentenaufbausystem

- 200: Tragprofilschiene

- 300: Brückenmodul
- 301: Modulrasteinrichtung
- 303: Steckkontakt
- 305: Brückenstecker

- 400: Funktionskomponente
- 401: Komponentenhalteeinrichtung
- 401-1: Komponentenhalteeinrichtung
- 401-2: Komponentenhalteeinrichtung
- 403: Rastschieber
- 405: Rastarm
- 407-1: Rastöffnung
- 407-2: Rastöffnung
- 409: Fixierfederarm
- 411: Druckelement
- 413: Öffnung
- 415: Unterstützungsabschnitt
- 417: Befestigungsnase
- 419: Anschlag
- 421-1: Gehäuseoberteil
- 421-2: Gehäuseunterteil
- 423: Ausnehmung
- 425: Druckfeder

- 500: Klemmelement/Klemmblock

## Patentansprüche

1. Komponentenaufbausystem (100) mit einer Tragprofilschiene (200), mit:
einer Funktionskomponente (400);
einem Brückenmodul (300) zum elektrischen Verbinden einer Funktionskomponente (400), das eine Modulhalteeinrichtung (301) zum Halten des Brückenmoduls (300) auf der Tragprofilschiene (200) umfasst; wobei
die Funktionskomponente (400) zum teilweisen Aufsetzen auf das Brückenmodul (300) ausgebildet ist, und wobei die Funktionskomponente (400) eine Komponentenhalteeinrichtung (401) zum Halten der Funktionskomponente (400) an der Tragprofilschiene (200) umfasst, wobei die Modulhalteeinrichtung (301) ausgebildet ist, eine Rastverbindung zwischen dem Brückenmodul (300) und der Tragprofilschiene (200) herzustellen,
**dadurch gekennzeichnet, dass**
die Funktionskomponente (400) auf das Brückenmodul (300) aufsetzbar ist, wobei die Modulhalteeinrichtung (301) durch einen Gehäuserand der Funktionskomponente (400) überdeckbar und dadurch gegen Auslösen arretierbar oder blockierbar ist; und wobei die Komponentenhalteeinrichtung (401)
einen Rastschieber (403) zum lösbaren Befestigen der Funktionskomponente (400) auf der Tragprofilschiene (200) umfasst, wobei der Rastschieber (403) ausgebildet ist, die Tragprofilschiene (200) formschlüssig zu umgreifen, wobei der Rastschieber (403) in eine vorgeschobene Arretierungsstellung zum Untergreifen der Funktionskomponente (400) auf der Tragprofilschiene (200) verschiebbar ist, und wobei der Rastschieber (403) in eine zurückgezogene Freigabestellung zum Aufsetzen der Funktionskomponente (400) auf die Tragprofilschiene (200) verschiebbar ist, und wobei der Rastschieber (403) einen Rastarm (405) zum Einrasten des Rastschiebers (403) in der Arretierungsstellung und zum Einrasten des Rastschiebers (403) in der Freigabestellung umfasst,
wobei der Rastschieber (403) eine Befestigungsnase (417) aufweist, die die Tragprofilschiene (200) so hintergreift, dass ein Formschluss entsteht, und dass der Rastarm (405) so ausgebildet ist, dass er je nach Stellung in eine erste Rastöffnung (407-1) oder eine zweite Rastöffnung (407-2) der Funktionskomponente (400) eingreift.

2. Komponentenaufbausystem (100) nach Anspruch 1, wobei die Modulhalteeinrichtung (301), insbesondere durch ein Schwenken des Brückenmoduls (300), auf die Tragprofilschiene (200) aufrastbar ist.

3. Komponentenaufbausystem (100) nach einem der vorstehenden Ansprüche, wobei die Modulhalteeinrichtung (301) ein die Tragprofilschiene (200) umgreifendes starres Halteelement und ein gegenüber dem starren Halteelement angeordnetes federelastisches Halteelement zum Aufrasten auf die Tragprofilschiene (200) umfasst.

4. Komponentenaufbausystem (100) nach einem der vorangehenden Ansprüche, wobei das Brückenmodul (300) und/oder die Funktionskomponente (400) auf oder entlang der Tragprofilschiene (200) verschiebbar sind.

5. Komponentenaufbausystem (100) nach einem der vorangehenden Ansprüche, das ein Klemmelement (500) zum Festsetzen des Brückenmoduls (300) gegen die Verschiebbarkeit auf der Tragprofilschiene (200) umfasst, wobei das Klemmelement (500) mit dem Brückenmodul (300) verbindbar ist.

6. Komponentenaufbausystem (100) nach Anspruch 5, wobei das Klemmelement (500) mit dem Brückenmodul (300) kraftschlüssig oder formschlüssig, insbesondere mittels einer T-Nut/Feder-Verbindung oder einer Schwalbenschwanzverbindung oder einer Schraubverbindung oder einer Klemmverbindung, verbindbar ist.

7. Komponentenaufbausystem (100) nach Anspruch 5 oder 6, wobei das Klemmelement (500) ausgebildet ist, die Tragprofilschiene (200) formschlüssig zu umgreifen und/oder kraftschlüssig zu klemmen.

8. Komponentenaufbausystem (100) nach Anspruch 5, 6 oder 7, wobei das Klemmelement (500) einen nach außen geführten Erdungsanschluss umfasst, welcher mit der Tragprofilschiene elektrisch leitend verbindbar ist.

9. Komponentenaufbausystem (100) nach einem der vorangehenden Ansprüche, wobei das Brückenmodul (300) Steckverbindungen zum elektrischen Verbinden mit der Funktionskomponente (400) umfasst.

10. Komponentenaufbausystem (100) nach einem der vorangehenden Ansprüche, wobei die Funktionskomponente (400) und das Brückenmodul (300) mittels einer formschlüssigen Verbindung, insbesondere einer Feder-Nut-verbindung, verbindbar sind, um die auf die Verbindung zwischen dem Verbindungsmodul (300) und der Funktionskomponente wirkenden Zugkräfte entlang einer Tragprofilschiene (200) aufzunehmen.

11. Komponentenaufbausystem (100) nach einem der vorangehenden Ansprüche, wobei die Komponentenhalteeinrichtung (401) einen verschiebbaren Rastschieber (403) zum Untergreifen oder zum formschlüssigen Umgreifen der Tragprofilschiene (200) aufweist.

12. Komponentenaufbausystem (100) nach Anspruch 11, wobei der Rastschieber (403) an der Funktionskomponente (400) zwischen einer vorgeschobenen Arretierungsstellung zum Untergreifen oder zum formschlüssigen Umgreifen der Funktionskomponente (400) auf der Tragprofilschiene (200) und einer zurückgezogenen Freigabestellung zum Aufsetzen der Funktionskomponente (400) auf die Tragprofilschiene (200) verschiebbar ist.

13. Komponentenaufbausystem (100) nach Anspruch 12, wobei der Rastschieber (403) einen Rastarm (405) zum Einrasten des Rastschiebers (403) in der Arretierungsstellung und zum Einrasten des Rastschiebers (403) in der Freigabestellung umfasst, wobei die Komponentenhalteeinrichtung (401) insbesondere eine erste Rastöffnung (407-1) und eine zweite Rastöffnung (407-2) für den Rastarm (405) umfasst.

## Claims

1. Component assembly system (100) having a profiled carrier rail (200), comprising:
a functional component (400);
a bridge module (300) for electrically connecting a functional component (400), which bridge module comprises a module retaining device (301) for retaining the bridge module (300) on the profiled carrier rail (200); wherein
the functional component (400) is designed to be partially placed on the bridge module (300), and wherein the functional component (400) comprises a component retaining device (401) for retaining the functional component (400) on the profiled carrier rail (200), wherein the module retaining device (301) is designed to establish a latching connection between the bridge module (300) and the profiled carrier rail (200),
**characterized in that**
the functional component (400) can be placed onto the bridge module (300), wherein the module retaining device (301) can be covered by a housing edge of the functional component (400) and thereby can be arrested or blocked to prevent release; and wherein the component retaining device (401) comprises a latching slide (403) for releasably fastening the functional component (400) to the profiled carrier rail (200), wherein the latching slide (403) is designed to engage around the profiled carrier rail (200) with a form fit, wherein the latching slide (403) can be displaced into a pushed-forward arresting position for engaging below the functional component (400) on the profiled carrier rail (200), and wherein the latching slide (403) can be displaced into a pulled-back release position for placing the functional component (400) onto the profiled carrier rail (200), and wherein the latching slide (403) comprises a latching arm (405) for latching the latching slide (403) in the arresting position and for latching the latching slide (403) in the release position,
wherein the latching slide (403) has a fastening protrusion (417) which engages behind the profiled carrier rail (200) such that a form fit is established, and the latching arm (405) is designed such that it engages in a first latching opening (407-1) or in a second latching opening (407-2) of the functional component (400), depending on the position.

2. Component assembly system (100) according to claim 1, wherein the module retaining device (301) can be latched onto the profiled carrier rail (200), in particular by pivoting the bridge module (300).

3. Component assembly system (100) according to one of the preceding claims, wherein the module retaining device (301) comprises a rigid retaining element which engages around the profiled carrier rail (200), and a flexible retaining element, arranged opposite the rigid retaining element, for latching onto the profiled carrier rail (200).

4. Component assembly system (100) according to one of the preceding claims, wherein the bridge module (300) and/or the functional component (400) are displaceable on or along the profiled carrier rail (200).

5. Component assembly system (100) according to one of the preceding claims, which comprises a clamping element (500) for securing the bridge module (300) against displacement on the profiled carrier rail (200), wherein the clamping element (500) can be connected to the bridge module (300).

6. Component assembly system (100) according to claim 5, wherein the clamping element (500) can be connected to the bridge module (300) with a force fit or form fit, in particular by means of a T-shaped tongue-and-groove connection or a dovetail connection or a screw connection or a clamping connection.

7. Component assembly system (100) according to claim 5 or 6, wherein the clamping element (500) is designed to engage around the profiled carrier rail (200) with a form fit and/or to clamp the latter with a force fit.

8. Component assembly system (100) according to claim 5, 6 or 7, wherein the clamping element (500) comprises a ground terminal which is routed to the outside and which can be electrically conductively connected to the profiled carrier rail.

9. Component assembly system (100) according to one of the preceding claims, wherein the bridge module (300) comprises plug-in connections for electrical connection to the functional component (400).

10. Component assembly system (100) according to one of the preceding claims, wherein the functional component (400) and the bridge module (300) can be connected by means of a form-fitting connection, in particular a tongue-and-groove connection, in order to absorb the tensile forces along a profiled carrier rail (200) which act on the connection between the connection module (300) and the functional component.

11. Component assembly system (100) according to one of the preceding claims, wherein the component retaining device (401) has a displaceable latching slide (403) for engaging below the profiled carrier rail (200) or for engaging around the latter with a form fit.

12. Component assembly system (100) according to claim 11, wherein the latching slide (403) on the functional component (400) can be displaced between a pushed-forward arresting position for engaging below the functional component (400) on the profiled carrier rail (200) or for engaging around said functional component with a form fit, and a pulled-back release position for placing the functional component (400) onto the profiled carrier rail (200).

13. Component assembly system (100) according to claim 12, wherein the latching slide (403) comprises a latching arm (405) for latching the latching slide (403) in the arresting position and for latching the latching slide (403) in the release position, wherein the component retaining device (401) comprises in particular a first latching opening (407-1) and a second latching opening (407-2) for the latching arm (405).

## Revendications

1. Système de montage de composants (100) avec un rail profilé support (200), comprenant :
un composant fonctionnel (400) ;
un module de pontage (300) pour la connexion électrique d'un composant fonctionnel (400) comportant un dispositif de maintien de module (301) pour le maintien du module de pontage (300) sur le rail profilé support (200) ; où
le composant fonctionnel (400) est prévu pour être partiellement mis en place sur le module de pontage (300), et où le composant fonctionnel (400) comprend un dispositif de maintien de composant (401) pour le maintien du composant fonctionnel (400) contre le rail profilé support (200), le dispositif de maintien de module (301) étant prévu pour réaliser un connexion par enclenchement entre le module de pontage (300) et le rail profilé support (200),
**caractérisé en ce que**
le composant fonctionnel (400) peut être mise en place sur le module de pontage (300), le dispositif de maintien de module (301) pouvant être recouvert par un bord de boîtier du composant fonctionnel (400) et être ainsi fixé ou bloqué pour prévenir un détachement ; et où le dispositif de maintien de composant (401) comporte une coulisse d'enclenchement (403) pour la fixation amovible du composant fonctionnel (400) sur le rail profilé support (200), ladite coulisse d'enclenchement (403) étant prévue pour enserrer le rail profilé support (200) par engagement positif, ladite coulisse d'enclenchement (403) étant déplaçable vers une position de fixation avancée pour venir en prise sous le composant fonctionnel (400) sur le rail profilé support (200), ladite coulisse d'enclenchement (403) étant déplaçable vers une position de dégagement arrière pour la mise en place du composant fonctionnel (400) sur le rail profilé support (200), et ladite coulisse d'enclenchement (403) comprenant un bras d'enclenchement (405) pour l'enclenchement de ladite coulisse d'enclenchement (403) en position de fixation et pour l'enclenchement de ladite coulisse d'enclenchement (403) en position de dégagement,
ladite coulisse d'enclenchement (403) présentant un ergot de fixation (417), en prise par l'arrière avec le rail profilé support (200) de manière à réaliser un emboîtement, et à configurer le bras d'enclenchement (405) pour engagement dans une première ouverture d'enclenchement (407-1) ou une deuxième ouverture d'enclenchement (407-2) du composant fonctionnel (400), en fonction de sa position.

2. Système de montage de composants (100) selon la revendication 1, où le dispositif de maintien de module (301) est enclenchable sur le rail profilé support (200), en particulier par pivotement du module de pontage (300).

3. Système de montage de composants (100) selon l'une des revendications précédentes, où le dispositif de maintien de module (301) comprend un élément de maintien fixe enserrant le rail profilé support (200) et un élément de maintien à élasticité de ressort opposé à l'élément de maintien fixe pour enclenchement sur le rail profilé support (200).

4. Système de montage de composants (100) selon l'une des revendications précédentes, où le module de pontage (300) et/ou le composant fonctionnel (400) sont mobiles sur le rail profilé support (200) ou le long de celui-ci.

5. Système de montage de composants (100) selon l'une des revendications précédentes, comprenant un élément de serrage (500) pour la fixation du module de pontage (300) empêchant la mobilité de celui-ci sur le rail profilé support (200), ledit élément de serrage (500) pouvant être raccordé au module de pontage (300).

6. Système de montage de composants (100) selon la revendication 5, où l'élément de serrage (500) peut être raccordé au module de pontage (300) par connexion à force ou à engagement positif, en particulier au moyen d'une liaison à rainure en T et languette ou à queue d'aronde ou à vis ou à serrage.

7. Système de montage de composants (100) selon la revendication 5 ou la revendication 6, où l'élément de serrage (500) est prévu pour enserrer le rail profilé support (200) par engagement positif et/ou à le serrer par friction.

8. Système de montage de composants (100) selon la revendication 5, la revendication 6 ou la revendication 7, où l'élément de serrage (500) comprend une borne de mise à la terre en liaison avec l'extérieur et pouvant être raccordée au rail profilé support de manière électriquement conductrice.

9. Système de montage de composants (100) selon l'une des revendications précédentes, où le module de pontage (300) comprend des connexions à fiche pour le raccordement électrique avec le composant fonctionnel (400).

10. Système de montage de composants (100) selon l'une des revendications précédentes, où le composant fonctionnel (400) et le module de pontage (300) peuvent être raccordés par engagement positif, en particulier au moyen d'une connexion à rainure et languette, pour supporter les efforts de traction exercés sur la liaison entre le module de pontage (300) et le composant fonctionnel le long d'un rail profilé support (200).

11. Système de montage de composants (100) selon l'une des revendications précédentes, où le dispositif de maintien de composant (401) présente une coulisse d'enclenchement (403) mobile destinée à venir en prise sous le rail profilé support (200) ou enserrer celui-ci par engagement positif.

12. Système de montage de composants (100) selon la revendication 11, où la coulisse d'enclenchement (403) contre le composant fonctionnel (400) est déplaçable entre une position de fixation avancée pour venir en prise sous le composant fonctionnel (400) ou enserrer celui-ci par engagement positif sur le rail profilé support (200), et une position de dégagement arrière pour la mise en place du composant fonctionnel (400) sur le rail profilé support (200).

13. Système de montage de composants (100) selon la revendication 12, où la coulisse d'enclenchement (403) comprend un bras d'enclenchement (405) pour l'enclenchement de la coulisse d'enclenchement (403) en position de fixation et pour l'enclenchement de la coulisse d'enclenchement (403) en position de dégagement, le dispositif de maintien de composant (401) présentant en particulier une première ouverture d'enclenchement (407-1) et une deuxième ouverture d'enclenchement (407-2) pour le bras d'enclenchement (405).
